## Europäisches Patentamt
## European Patent Office
## Office européen des brevets

(19)

(11) Veröffentlichungsnummer : **0 222 927**
**B1**

(12) **EUROPÄISCHE PATENTSCHRIFT**

(45) Veröffentlichungstag der Patentschrift :
15.06.88

(51) Int. Cl.⁴ : **H 03 F 1/54,** H 03 F 3/24,
H 03 F 3/189, H 03 G 3/20

(21) Anmeldenummer : 85114674.6

(22) Anmeldetag : 19.11.85

(54) **Hochfrequenzverstärker.**

(73) Patentinhaber : **HERFURTH GMBH**
**Beerenweg 6 - 8**
**D-2000 Hamburg 50 (DE)**

(72) Erfinder : **Knobbe, Karl Heinz**
**Am Teich 7**
**D-2087 Ellerbek (DE)**
Erfinder : **Nöldge, Hellmut**
**Oberstrasse 40**
**D-2000 Hamburg 13 (DE)**

(74) Vertreter : **Patentanwälte Dipl.-Ing. J. Richter Dipl.-**
**Ing. F. Werdermann**
**Neuer Wall 10**
**D-2000 Hamburg 36 (DE)**

(43) Veröffentlichungstag der Anmeldung :
27.05.87 Patentblatt 87/22

(45) Bekanntmachung des Hinweises auf die Patenterteilung : 15.06.88 Patentblatt 88/24

(84) Benannte Vertragsstaaten :
**CH DE FR GB IT LI**

(56) Entgegenhaltungen :
FR-A- 1 492 932
US-A- 2 928 051
US-A- 3 365 675
**BROWN BOVERI REVIEW, Band 71, Nr. 6/7, Juni/Juli**
**1984, Seiten 272-276, Baden, CH; W. SCHMINKE:**
**"High-power amplifiers for plasma heating"**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf einen Hochfrequenzverstärker für die Ankopplung einer Last mit veränderlichen Betriebsverhältnissen, insbesondere einer Last in Form des mit der Hochfrequenzenergie zu beheizenden Plasmas in einem Versuchsreaktor zur Kernfusion, mit einer Tetrode als Verstärkerröhre, die mit einer Regelschaltung mit Sollwerteinsteller für die Anodenspannung versehen ist.

Die Betriebsverhältnisse der Last werden bestimmt durch die Hochfrequenzwerte, d. h. durch die reellen (d. h. ohmschen) und die reaktiven (kapazitiven oder induktiven) Komponenten des Lastwiderstandes. Im Idealfall der Anpassung weist die Last einen rein ohmschen Widerstand ohne reaktive Komponente auf.

Die Fehlanpassung ist definierbar als das Stehwellenverhältnis s, d. h. das Verhältnis zwischen der reellen, vorlaufenden Leistung und der reaktiven, zurücklaufenden Leistung. Beim Gleichgewicht beider ist s = ∞, bei nur vorlaufender Leistung ist s = 1.

Bei der Verwendung von Hochfrequenzenergie zur Beheizung von Plasma in Versuchsreaktoren zur Kernfusion werden Frequenzen der Ionen-Zyklotron-Resonanz eingesetzt. Diese Resonanzfrequenzen liegen bei den heutigen Fusionsreaktoren im Bereich zwischen 10 und 120 MHz. Für die Plasmabeheizung werden sehr hohe Hochfrequenzleistungen der hierfür eingesetzten Generatoren benötigt. Die Größenordnung liegt z. Zt. bei 2 MW pro Generator. Es sind Senderöhren verfügbar, die grundsätzlich in der Lage sind, derartige Leistungen bereitzustellen. Es finden hauptsächlich Hochleistungstetroden Anwendung. Diese lassen jedoch an ihren Elektroden nur begrenzte Verlustleistungen zu, deren Überschreitung die Zerstörung der Röhre zur Folge hat.

Eine entscheidende Grenze für die Leistungsfähigkeit solcher Röhren ist die Anodenverlustleistung. Diese hängt weitgehend von der an der Röhre vorhandenen Fehlanpassung ab. Diese Fehlanpassung entsteht dadurch, daß das zu heizende Plasma des Reaktors nicht konstant ist, sondern während der Beheizung stark veränderliche Hochfrequenzwerte aufweist. Diese werden über die Antenne, die koaxiale Hochfrequenzleitung und die Anpassungselemente des Generators als Fehlanpassung an die Röhrenanode transformiert. Als optimale Anpassung ist ein auf einen entsprechenden Wert transformierter reeller Widerstand anzusehen. Außerdem ist die erforderliche Frequenzbandbreite eines solchen Verstärkers bei konstanter Leistung relativ hoch gewählt. Beispielsweise beträgt diese Bandbreite bei 50 MHz Mittenfrequenz ± 2 MHz. Auf der angeschlossenen Hochfrequenzleitung kann eine Fehlanpassung von s = 1,5 oder mehr auftreten. Dies hat zur Folge, daß infolge der Transformation im Anodenkreis die Fehlanpassung an der Röhre Werte von s = 2,6 oder mehr annehmen kann. Für die verschiedenen Phasenlagen ergeben sich starke Außenwiderstandsänderungen für die Senderöhre.

Die abgegebene Hochfrequenzleistung einer Verstärkerstufe errechnet sich aus der Differenz zwischen der eingegebenen Leistung $I_a$ x $U_a$ und der Anodenverlustleistung.

Bei kleiner werdendem Außenwiderstand muß der Anodenstrom erhöht werden, damit eine bestimmte geforderte Leistung erhalten wird. Dadurch erhöht sich unter der Annahme, daß die Anodenspannung konstant bleibt, die Anodenverlustleistung. Die zulässige Anodenverlustleistung ist jedoch für jede Röhre begrenzt.

Es ist daher bereits ein Hochfrequenzverstärker für die Ankopplung einer Last mit veränderlichen Betriebsverhältnissen, insbesondere einer Last in Form des mit der Hochfrequenzenergie zu beheizenden Plasmas in einem Versuchsreaktor zur Kernfusion vorgeschlagen worden, bei dem eine Tetrode als Verstärkerröhre, die mit einer Regelschaltung mit sollwerteinsteller für die Anodenspannung versehen ist, vorgesehen ist. Die Regeleinrichtung ist dabei so ausgelegt, daß verhindert wird, daß die Ausgangselektrode durch Reflexionen, d. h. durch Änderungen der Last, beschädigt werden kann. Hierbei wird ein PIN (Positive Intrinsic Negative)-diode-suppressor verwendet, um die Amplitude zu steuern und die Freigabe des Pulses auszulösen. Dieses Dämpfungsglied hat zusätzlich zu seinen Steuerungsaufgaben Schutzfunktionen. Wenn z. B. Reflexionen am Verstärkerausgang auftreten, wird die auf die Ladung übertragene Leistung auf einem vorgegebenen Wert gehalten unter der Voraussetzung, daß keiner der Verstärkergrenzwerte überschritten wird. Falls jedoch das letztere eintritt, wird die Eingangsleistung entsprechend reduziert innerhalb eines Zeitraumes, der nicht größer als 1 ms ist. Dabei ist die Steuerungsvariable die an die Last übertragene Leistung $P_L = P_+ — P_-$, wobei $P_+$ die der Last zufließende Leistung und $P_-$ die von der Last reflektierte Leistung ist.

Die Steuerungsleistung ist durch eine in einem Begrenzer programmierte Funktion so beschränkt, daß die Endstufen-Tetrode nicht durch Reflexionen beschädigt werden kann (Brown Boveri Review, Bd. 71 (1984), Nr. 6/7, s. 272-276).

Der vorliegenden Erfindung liegt demgegenüber die Aufgabe zugrunde, bei einem Hochfrequenzverstärker der eingangs genannten Art dafür zu sorgen, daß bei Einhaltung einer bestimmten geforderten Leistung die Anodenverlustleistung selbsttätig in Abhängigkeit von der jeweiligen Fehlanpassung unterhalb einer für die Röhre schädlichen Grenze gehalten wird.

Ein Maß für die maximale Aussteuerung einer Tetrode und damit für die kleinstmögliche Anodenverlustleistung ist der Schirmgitterstrom. Der Schirmgitterstrom kommt zustande, wenn der Spitzenwert der Anodenwechselspannung größer wird als die Differenz zwischen Anodenspannung und Schirmgitterspannung. Der

Schirmgitterstrom steigt danach sehr schnell an. Der Strom beginnt teilweise über das Schirmgitter statt über die Anode zu fließen.

Die Aussteuerung einer Tetrode ist ein Indikator für ihren Wirkungsgrad. Wenn der Schirmgitterstrom dazu herangezogen wird, die Höhe der erforderlichen Anodenspannung einzustellen, so ergibt sich bei den jeweiligen Betriebsverhältnissen der Röhre eine sehr einfache und wirkungsvolle Optimierung des Wirkungsgrades und eine Minimierung der Anodenverlustleistung.

Von dieser Überlegung ausgehend wird die vorstehend genannte Aufgabe erfindungsgemäß dadurch gelöst, daß die Regelschaltung für die Anodenspannung zusätzlich durch eine vom Schirmgitterstrom der Tetrode abhängige, zur selbsttätigen Anpassung der Anodenspannung an die Betriebsverhältnisse der Last dienende Stellgröße als Sollwertaufschaltung beeinflußbar ist.

Dadurch wird bei Aufrechterhaltung der im Lastkreis erforderlichen Leistung eine selbsttätige Begrenzung der Anodenverlustleistung auf ein für die Röhre unschädliches Maß erreicht.

Ein solcher Hochfrequenzverstärker arbeitet voll zufriedenstellend, sofern die Frequenz der Energiequelle, welche zur Lieferung der Anodenspannung dient und den die Anodenspannung einstellenden « inneren » Regelkreis speist, genügend groß und das für diesen Regelkreis benutzte Stellglied genügend schnell wirksam ist, um einen störenden Zeitverzug zwischen jeweils einem Stellbefehl und dessen Ausführung bzw. zwischen Stellgrößeneingabe und Istwert-Berichtigung der Anodenspannung zu vermeiden.

In der Praxis ist jedoch mit einem störenden Zeitverzug zu rechnen. Die Reaktion der Regelschaltung für die Anodenspannung mit der Sollwertaufschaltung hat eine verhältnismäßig große Zeitkonstante. Diese ist größer als die thermische Zeitkonstante des Schirmgitters der Röhre. Das Schirmgitter kann beschädigt werden, wenn die Schirmgitterverlustleistung größer wird als ihr im Dauerbetrieb maximal zulässiger Wert. Es besteht jedoch die Möglichkeit, den Schirmgitterstrom und auch die Anodenverlustleistung selbsttätig durch eine Begrenzung der ansteuernden Hochfrequenzleistung auf für die Röhre unschädlichen Werten zu halten.

Die Anwendung dieser Maßnahme für sich allein würde jedoch dazu führen, daß bei stark veränderlicher Last kein optimaler HF-Leistungsentzug am Ausgang des Verstärkers und keine ausreichende Begrenzung der Anoden- und Schirmgitterverlustleistung möglich ist. Wird nämlich die Anodenspannung auf einen Höchstwert eingestellt, der einem großen Lastwiderstand entspricht, so kann eine starke Verkleinerung des tatsächlichen Lastwiderstandes infolge der Betriebsverhältnisse einer stark veränderlichen Last, wie z. B. eines mit der Hochfrequenzenergie zu beheizenden Plasmas eintreten. Dann ergibt sich eine niedrige Anodenspannung und ein hoher Anodenstrom, was zur Folge haben kann, daß die Anodenverlustleistung, die sich aus der eingegebenen Leistung $I_a \times U_a$ abzüglich der abgegebenen Hochfrequenzleistung ergibt, ihren zulässigen Wert überschreitet.

In Verbindung mit dem Erfindungsvorschlag, der es ermöglicht, bei Einhaltung einer geforderten Ausgangsleistung die Anodenverlustleistung selbsttätig unterhalb eines für die Röhre schädlichen Grenzwertes zu halten, ist jedoch die zusätzliche Anwendung einer schnellwirkenden Regelschaltung zur Begrenzung der Schirmgitter- und Anodenverlustleistung in Abhängigkeit von der ansteuernden Hochfrequenzleistung ein vorteilhafter ergänzender Weg zur Überwindung der nachteiligen Folgen der erwähnten großen Zeitkonstante der Anodenspannungsregelschaltung unter Einhaltung der geforderten Ausgangsleistung des Verstärkers.

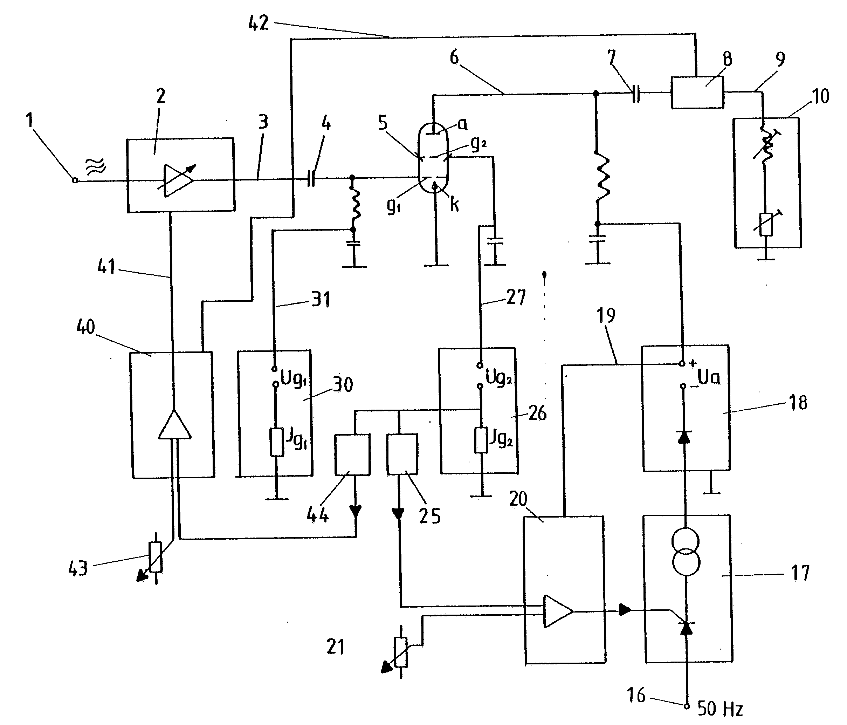

Im folgenden ist die Erfindung anhand eines in der Zeichnung dargestellten Ausführungsbeispiels näher erläutert.

In der Schaltung des als Ausführungsbeispiel gezeigten Hochfrequenzverstärkers ist 1 der HF-Eingang. Von hier aus gelangt die Hochfrequenz über einen Vorverstärker 2 und einen weiterhin in der Eingangsleitung 3 liegenden Abblockkondensator 4 zu der die Verstärkerröhre bildenden Tetrode 5, deren Anode mit a, die Kathode mit k, das Steuergitter $g_1$ und das Schirmgitter mit $g_2$ bezeichnet ist. Von der Anode a führt eine Leitung 6 über einen Abblockkondensator 7 zu dem HF-Ausgang 8. An diesen ist über eine Leitung 9 eine die Last 10 bildende veränderliche Impedanz angeschlossen, z. B. eine an ein Plasma angekoppelte Antenne.

Mit der Leitung 6 ist die Anodenspannungsquelle verbunden. 16 ist deren Eingangsanschluß, 17 ein Transformator mit Thyristorsteller, 18 ein Gleichrichter mit Abgriffanschluß für den Istwert der Anodenspannung, der über eine Leitung 19 dem Regelsatz 20 zugeführt wird. Zu diesem gehört eine Einstellvorrichtung 21 für den festen Sollwert. Diese Teile bilden den « inneren » Regelkreis der Anodenspannung.

Der Regelsatz 20 hat noch eine zweite Eingangsleitung zur Eingabe einer Stellgröße 25 als Sollwertaufschaltung. Die Stellgröße 25 wird aus einem Abgriffanschluß 26 in einer mit dem Schirmgitter $g_2$ der Tetrode 5 verbundenen Leitung 27 erhalten, sobald ein Schirmgitterstrom fließt bzw. eine Schirmgitterspannung auftritt.

Auch das Steuergitter $g_1$ der Tetrode 1 ist durch eine Leitung 31 mit einer Einrichtung 30 verbunden, mit der die jeweilige Größe der Gittervorspannung und des Gittergleichstromes feststellbar sind.

Ferner ist ein Regelsatz 40 vorgesehen, der über eine Leitung 41 mit dem Vorverstärker 2 verbunden ist und zur Regelung der ansteuernden Hochfrequenzleistung dient. Er ist durch eine Leitung 42 mit dem HF-Ausgang 8 des Verstärkers verbunden und mit einem Sollwerteinsteller 43 versehen. Außerdem wird eine vom Schirmgitterstromabgriff 26 abhängige Stellgröße 44 zur Begrenzung der Hochfrequenzleistung auf den Regelsatz 40 gegeben.

Durch diese Maßnahmen wird es möglich, auch bei stark schwankenden Hochfrequenzwerten der Last eine bestimmte geforderte Leistung am Ausgang des Hochfrequenzverstärkers einzuhalten, die Verlustleistungen an der Anode und am Schirmgitter der Tetrode auf für die Röhre unschädliche Werte zu begrenzen und dabei zugleich die unerwünschten Auswirkungen der bei Verwendung des Wechselstromnetzes als Energiequelle für den Anodenspannungsregelsatz unvermeidlichen hohen Zeitkonstanten zu vermeiden.

**Patentansprüche**

1. Hochfrequenzverstärker für die Ankopplung einer Last (10) mit veränderlichen Betriebsverhältnissen, insbesondere einer Last in Form des mit der Hochfrequenzenergie zu beheizenden Plasmas in einem Versuchsreaktor zur Kernfusion, mit einer Tetrode (5) als Verstärkerröhre, die mit einer Regelschaltung (17, 18, 19, 20) mit Sollwerteinsteller (21) für die Anodenspannung versehen ist, dadurch gekennzeichnet, daß die Regelschaltung zusätzlich durch eine vom Schirmgitterstrom der Tetrode (5) abhängige, zur selbsttätigen Anpassung der Anodenspannung an die Betriebsverhältnisse der Last dienende Stellgröße als Sollwertaufschaltung beeinflußbar ist.

2. Hochfrequenzverstärker nach Anspruch 1, dadurch gekennzeichnet, daß zur schnellen Begrenzung der Verlustleistung von Schirmgitter ($g_2$) und Anode (a) der Tetrode (5) eine Regelschaltung mit vom Schirmgitterstrom abhängiger Begrenzung der ansteuernden Hochfrequenzleistung vorgesehen ist.

**Claims**

1. High-frequency amplifier for the coupling of a load (10) with variable operating environments, particularly of a load in the form of the plasma to be heated with the highfrequency energy in an experimental reactor for thermonuclear fusion, with a tetrode (5) as an amplifier tube, which is provided with a regulator circuit (17, 18, 19, 20) with a setpoint adjuster (21) for the anode voltage, characterized in that the regulator circuit can be additionally influenced by a correcting variable as a nominal value intrusion depending on the control grid power of the tetrode (5) and allowing the automatic adaptation of the anode power to the operating environments of the load.

2. High-frequency amplifier according to claim 1, characterized in that, for quick limitation of the power loss of the control grid ($g_2$) and anode (a) of the tetrode (5), a regulator circuit is provided with a control-grid dependent limitation of the selecting high-frequency power.

**Revendications**

1. Amplificateur haute fréquence pour l'accouplement d'une charge (10) au régime de fonctionnement variable, en particulier d'une charge sous forme de plasma à chauffer à l'énergie haute fréquence dans un réacteur expérimental pour la fusion nucléaire, avec une tétrode (5) comme lampe amplificatrice pourvue d'un couplage de réglage (17, 18, 19, 20) avec ajusteur de consigne (21) pour la tension anodique, caractérisé en ce que le couplage de réglage peut être influencé en plus par une variable réglante comme intrusion de consigne qui est fonction du courant de grille-écran de la tétrode (5) et qui sert à la correction automatique de la tension anodique au régime de fonctionnement de la charge.

2. Amplificateur haute fréquence selon la revendication 1, caractérisé en ce qu'il est prévu un couplage de réglage avec limitation de la puissance haute fréquence de commande qui est fonction du courant de grille-écran pour la limitation rapide de la dissipation de puissance de la grille-écran ($g_2$) et de l'anode (a) de la tétrode (5).